# EUROPÄISCHE PATENTANMELDUNG

(11) **EP 1 400 339 A1**
(43) Veröffentlichungstag der Anmeldung: **24.03.2004**
(21) Anmeldenummer: 02020817.9
(22) Anmeldetag: 17.09.2002
(51) Int. Cl.: B29C 67/00, B22F 3/105

(54) **Verfahren zum Herstellen eines dreidimensionalen Formkörpers**

(71) Anmelder: SIEMENS AKTIENGESELLSCHAFT, 80333 München (DE)
(72) Erfinder: Bostanjoglo, Georg, Dr., 12161 Berlin (DE); Cox, Nigel-Philip, 10119 Berlin (DE); Wilkenhöner, Rolf, Dr., 10589 Berlin (DE)

(57) **Zusammenfassung**

Verfahren nach dem Stand der Technik zur Herstellung von dreidimensionalen Formkörpern benötigen in der Regel äußere Formen, die die Geometrie eines herzustellenden Bauteils vorgeben.

Eine solche Form ist mit dem erfindungsgemässen Verfahren zur Herstellung dreidimensionaler Formkörper nicht mehr notwendig. Die Geometrie des herzustellenden Bauteils wird durch eine vorgegebene Laserführung oder die Geometrie der verwendeten Teilmengen (7,10,52) bestimmt.

## Beschreibung

Die Erfindung betrifft ein Verfahren zum Herstellen eines dreidimensionalen Formkörpers.

Aus der DE 199 03 436 C2 ist ein Verfahren zur Herstellung dreidimensionaler Formkörper bekannt, bei dem zuerst ein Hüllkörper aufgebaut wird und anschließend mit einem zweiten Material zumindest teilweise gefüllt wird. Der Hüllkörper ist eine wesentliche Voraussetzung für das Verfahren.

Die EP 892 090 A1 zeigt ein Verfahren zur Reparatur eines dreidimensionalen Körpers, bei dem nur im oberflächennahen Bereich eine Schicht aufgetragen wird.

Die US-PS 4,085,415, die US-PS 3,939,895, die US-PS 4,543,235 sowie die US-PS 4,036,599 zeigen Verfahren, um in gegossenen Bauteilen Fasern einzubringen.
Zum Giessen werden Gussschalen benötigt.

Die DE 100 24 343 A1 sowie die EP 0 799 904 B1 zeigen Verfahren zur Erzeugung von Gradienten in einem metallischen oder einem keramischen Gefüge.

Es ist daher Aufgabe der Erfindung ein Verfahren aufzuzeigen, bei dem auf einfache Art und Weise ein dreidimensionaler Formkörper hergestellt werden kann.

Die Aufgabe wird gelöst durch ein Verfahren gemäß Anspruch 1. Dabei werden verschiedene Konsistenzen zumindest zweier schichtförmiger Teilmengen zumindest eines Ausgangsmaterials zu einem dreidimensionalen Formkörper verbunden.

Vorteilhafte Weiterbildungen der Erfindung ergeben sich aus den Unteransprüchen.

Es zeigen
Figur 1 eine beispielhafte Vorrichtung, mit der das erfindungsgemäße Verfahren durchgeführt wird,
Figur 2 einen weiteren Verfahrensschritt des erfindungsgemäßen Verfahrens,
Figur 3 einen Querschnitt einer Teilmenge, die mittels dem erfindungsgemäßen Verfahren verarbeitet wird und
Figur 4 einen weiteren Querschnitt einer Teilmenge,
Figur 5 eine Teilmenge mit Fasern,
Figur 6 eine weitere Vorrichtung, um das erfindungsgemässe Verfahren durchzuführen, und
Figur 7 eine weitere beispielhafte Vorrichtung, mit der das erfindungsgemäße Verfahren durchgeführt wird.

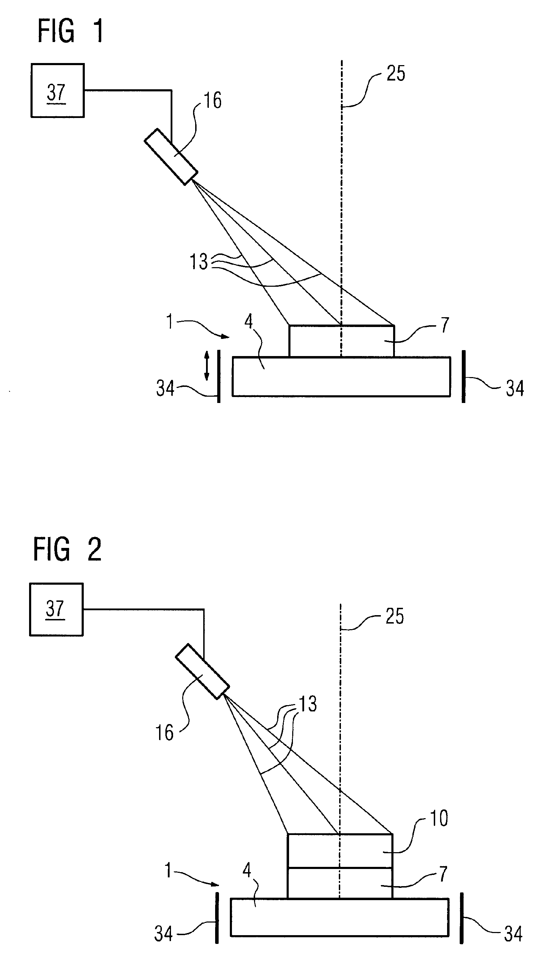

Figur 1 zeigt eine beispielhafte Vorrichtung 1, um das erfindungsgemäße Verfahren durchzuführen.

Innerhalb einer optional vorhandenen Heizung 34 ist bspw. eine Startplatte 4 angeordnet, auf der eine erste schichtförmige Teilmenge 7 aus zumindest einem ersten Ausgangsmaterial aufliegt.
Die Teilmenge 7 kann gegenüber der Heizung 34 in einer Aufbaurichtung 25 des dreidimensionalen Formkörpers verschoben werden oder die Heizung 34 wird gegenüber der Teilmenge 7 bzw. dem aufzubauenden Formkörper verschoben.

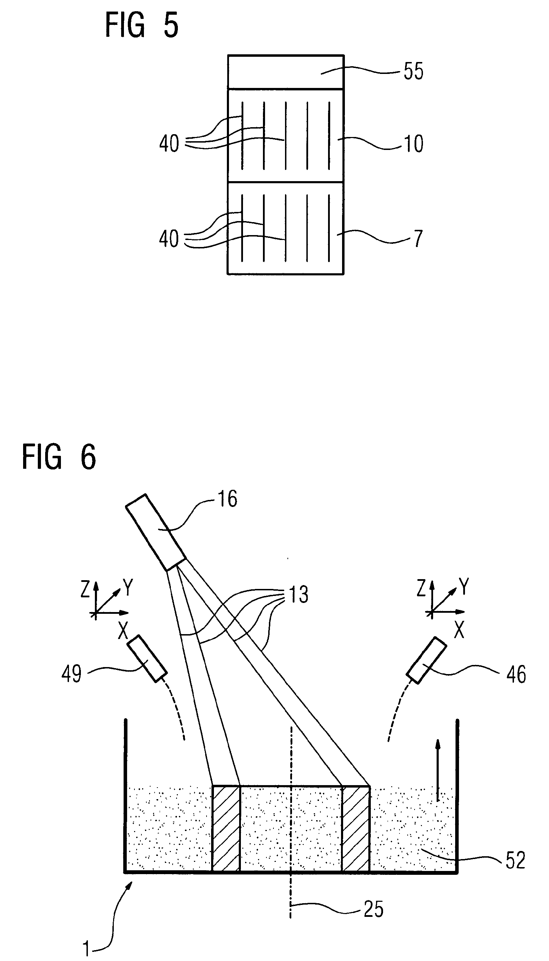

Aus der schichtförmigen Teilmenge 7 wird ein dreidimensionaler Formkörper, bspw. eine Turbinenschaufel hergestellt.
Die Teilmenge 7 ist von der Konsistenz her bspw. ein schichtförmiger Pulverpressling, eine schichtweise aufzubauende Pulverschüttung 52 (Fig. 6) oder ein Blech bzw. eine Metallfolie (beide schichtförmig).

Im Falle von Metallfolien oder Blechen schneidet bspw. zumindest ein Laser 16 die gewünschte Geometrie für den herzustellenden dreidimensionalen Formkörper heraus, wenn diese noch nicht vorliegt.

In einem der ersten Verfahrensschritte wird die erste schichtförmige Teilmenge 7 bspw. verdichtet. Dies ist bei Pulverpresslingen und Pulverschüttungen notwendig, nicht unbedingt bei Blechen oder Metallfolien.
Dies kann durch bekannte thermische Verdichtungsverfahren (Sintern) oder mit Laserstrahlen 13 oder Elektronenstrahlen erfolgen, die aus dem Laser 16 stammen und die Teilmenge 7 beaufschlagen (Lasersintern).
Die Laserstrahlen 13 können die erste Teilmenge 7 ganz oder teilweise bedecken und das Material der ersten Teilmenge 7 sogar ggf. aufschmelzen.

Der Laser 16 und/oder seine Laserstrahlen 13 können ihre Position gegenüber der ersten Teilmenge 7 in allen Raumrichtungen verändern. In einer Steuerungseinheit 37 ist ein CAD Modell des dreidimensionalen Formkörpers abgespeichert, so dass der/die Laser 16/Laserstrahlen 13 so gesteuert werden, dass aus der ersten Teilmenge 7 und weiteren Teilmengen 10 (Fig. 2) der gewünschte dreidimensionale Formkörper mit seinen äußeren und inneren Abmessungen gemäß des CAD Modells entsteht.
Der Laser 16 kann bewirken, dass die Teilmenge 7 verdichtet wird und ggf. eine Formgebung der ersten Teilmenge 7 erfolgt. Eine Formgebung muss bspw. nicht erfolgen, wenn der Pulverpressling in seiner Form bereits dem entsprechenden Teil des dreidimensionalen Formkörpers bspw. nach seiner Schrumpfung nach der Verdichtung entspricht.
Zur Fertigstellung des Formkörpers werden so viele schichtförmige Teilmengen 10 benötigt, wie es der Höhe des Formkörpers in der Aufbaurichtung 25 entspricht.

Figur 2 zeigt einen weiteren Verfahrensschritt des erfindungsgemäßen Verfahrens.

Auf die erste Teilmenge 7 wird eine zweite schichtförmige Teilmenge 10 angeordnet.
Die zweite Teilmenge 10 besteht, aber nicht notwendigerweise, bspw. aus einem zweiten Ausgangsmaterial, um bspw. einen Materialgradienten im Formkörper zu erzeugen.
Die zweite Teilmenge 10 wird bspw. ebenfalls verdichtet, insbesondere durch Beaufschlagung mit Laserstrahlen 13.
Der Laser 16 bewirkt ggf. auch eine Formgebung der zweiten Teilmenge 10.
Durch die thermische Behandlung, bspw. durch die Laserbehandlung, werden die schichtförmigen Teilmengen 7, 10 miteinander verbunden, bspw. durch Versinterung oder Verschmelzung.

Eine weitere Möglichkeit zur Herstellung eines dreidimensionalen Formkörpers besteht darin, dass der aus den zumindest zwei Teilmengen 7, 10 herzustellende dreidimensionale Formkörper eine gerichtet erstarrte Struktur aufweist, d.h. eine einkristalline Struktur (SX) oder nur Korngrenzen (DS) entlang einer Richtung (Aufbaurichtung 25). Dies kann beispielsweise dadurch erfolgen, dass bspw. die Startplatte 4 eine gewünschte kristalline Struktur des herzustellenden dreidimensionalen Formkörpers aufweist.
Für dieses Verfahren wird im ersten Schritt (Figur 1) die erste Teilmenge 7 aufgeschmolzen und kontrolliert abgekühlt, wobei die gewünschte kristalline Struktur entsteht.
In einem zweiten Schritt (Figur 2) wird die zweite Teilmenge 10 aufgelegt und aufgeschmolzen, wodurch sie sich mit der ersten Teilmenge 7 verbindet. Ggf. wird die erste Teilmenge 7 an der Oberfläche leicht aufgeschmolzen.
Durch geeignete Führung bspw. der Heizung 34 und/oder eine Erwärmung durch den Laser 16 wandert die Erstarrungsfront mit der gewünschten kristallinen Struktur aus der ersten Teilmenge 7 in der zweiten Teilmenge 10 weiter.
Dieses Verfahren kann beliebig oft wiederholt werden. Bezüglich der Wachstumsbedingungen zum Herstellen von kristallinen Strukturen mittels epitaktischem Wachstum ist hier auf die EP 892 090 A1 verwiesen, die ausdrücklich Bestandteil dieser Offenbarung sein soll.
Durch die Verwendung des Lasers 16, d.h. einer entsprechenden Bewegung der Laserstrahlen über die Teilmengen 7, 10, werden bspw. nur die Bereiche der Teilmengen 7, 10 verdichtet oder aufgeschmolzen, die den Maßen des gewünschten herzustellenden dreidimensionalen Formkörpers entsprechen. Die Teilmengen 7, 10 müssen in ihren Abmessungen also nicht dem gewünschten dreidimensionalen Formkörper entsprechen.
Eine äußere Form oder Hülle, wie z. B. beim Gießen notwendig ist, ist hier nicht notwendig.
Das Verbinden der schichtförmigen Teilmengen wird so oft wiederholt bis der Formkörper entstanden ist.
Der Formkörper ist komplett nur aus einzelnen Schichten, die beispielsweise 0,1 mm bis 1 cm dick sind, entstanden. Insbesondere ist der Formkörper senkrecht zu einer Ebene, in der sich die schichtförmigen Teilmengen 7, 10 erstrecken, länger als die Ausdehnung des Formkörpers in dieser Ebene, wie es bspw. bei einer Turbinenschaufel der Fall ist. Eine solche Turbinenschaufel wird bspw. beginnend mit dem Schaufelfuss Schicht für Schicht bis zur Schaufelspitze hergestellt.

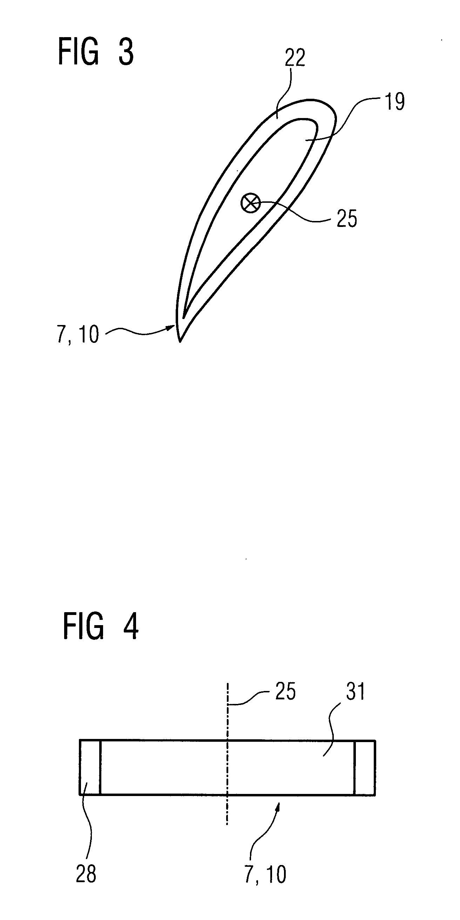

Figur 3 zeigt einen Querschnitt einer Teilmenge 7, 10 senkrecht zur Aufbaurichtung 25.
Die Teilmenge 7 ist beispielsweise ein Pulverpressling, der im Inneren einen Hohlraum 19 aufweist, der von einer Wand 22 umschlossen wird. Solche hohlen Bauteile werden insbesondere als Turbinenschaufeln (dreidimensionales Bauteil) verwendet, die im Inneren 19 gekühlt werden und von einer äusseren Wand 22 umschlossen sind.

Die Teilmenge 7, 10 kann auch ein Pulverpressling sein, der keinen Hohlraum 19 aufweist.
Durch eine geeignete Führung der Laserstrahlen 13 werden nur die Bereiche der Teilmenge 7, 10 verdichtet oder aufgeschmolzen und erstarren gelassen, die der Wand 22 des herzustellenden Bauteils (dreidimensionalen Formkörper) entsprechen. Das gepresste Pulver in der Mitte bleibt unverdichtet und lose und kann nach der Herstellung des dreidimensionalen Formkörpers leicht entfernt werden.
Ebenso können Metallbleche oder Folien verwendet werden, die durch den Laser 16 ihre äußere und innere Form erhalten und danach aufgeschmolzen werden.

Figur 4 zeigt weitere Teilmengen 7, 10.
Die Teilmenge 7, 10 ist bspw. ein Pulverpressling und kann in ihrer Zusammensetzung einen Gradienten oder einen Schichtaufbau in Aufbaurichtung 25 oder in der Ebene senkrecht zur Aufbaurichtung 25 aufweisen. Letzteres ist in Figur 4 der Fall.
In einem inneren Bereich 31 besteht die Teilmenge 7, 10 beispielsweise aus einem Material, beispielsweise einem Pulver für eine Nickel- oder Kobalt-basierte Superlegierung. Im äußeren Bereich ist der Innenbereich 31 durch eine Schicht 28 umhüllt, die eine andere Materialzusammensetzung als die des Innenbereichs 31 aufweist. Dies ist z.B. ein Pulver für eine MCrAlY-Schicht, wobei M für Element der Gruppe Eisen, Kobalt oder Nickel steht.
Bei der Beaufschlagung der Teilmengen 7, 10, 52 mit den Laserstrahlen 13 werden ggf. deren Parameter (Intensität, Wellenlänge, Grösse,..) dem Gradienten angepasst.

Figur 5 zeigt beispielhaft eine erste Teilmenge 7, eine zweite Teilmenge 10, in denen Fasern 40 angeordnet sind und eine weitere Teilmenge 55.
Die Fasern 40 können gerichtet oder wahllos durcheinander angeordnet sein. Ebenso können Fasermatten verwendet werden. Die Fasern 40 können in Pulverpresslingen 7, 10 mit eingepresst worden sein oder bereits in den Blechen vorhanden sein.
Die nächste schichtförmige Teilmenge 55 kann, muss aber keineswegs ebenfalls keine Fasern aufweisen, weil bspw. dort keine mechanische Verstärkung notwendig ist. Der dreidimensionale Formkörper weist somit einen Materialgradienten auf, wie er im Grundsatz auch in Figur 4 vorliegt.

Figur 6 zeigt eine weitere Vorrichtung 1, um das erfindungsgemässe Verfahren durchzuführen.
Der Laser 16 beaufschlagt mit seinen Laserstrahlen 13 eine Pulverschüttung 52, die eine weitere Konsistenz des zumindest einen Ausgangsmaterials darstellt.
Das Verfahren wird gestartet mit einer bestimmten Menge von Pulver eines ersten Ausgangsmaterials, die die Pulverschüttung 52 darstellt (erste Teilmenge 7).
Über eine erste und/oder auch eine zweite Materialzufuhr 46, 49 wird kontinuierlich oder diskontinuierlich der Pulverschüttung 52 weiteres Material in Form von Pulver (zweite Teilmenge 10) hinzugeführt, so dass die Pulverschüttung 52 schichtweise in der Aufbaurichtung 25 zunimmt.
Die Zusammensetzung des zugeführten Materials kann sich durch Zugabe eines zweiten Ausgangsmaterial zum ersten Ausgangsmaterial verändern, um eine gleichmässige Verteilung einer Zweitphase zu erhalten (Materialzufuhr für zweites Ausgangsmaterial ist zeitlich und örtlich, bezogen auf die Pulverschüttung 52, konstant) oder um einen Materialgradienten in der Teilmenge zu erzeugen (Materialzufuhr für zweites Ausgangsmaterial örtlich, bezogen auf die Pulverschüttung 52, und ggf. zeitlich verschieden). Die Materialzufuhren 46, 49 können in allen Richtungen (x,y,z) örtlich bewegt werden.
Die erste Materialzuführung 46 führt bspw. ein Matrixmaterial zu und die zweite Materialzuführung 49 kann bspw. Fasern, Zweitphasen oder andere Bestandteile zuführen.
Mit den Laserstrahlen 13 werden nur die Bereiche der Pulverschüttung 52 verdichtet, die in einem vorgegebenen CAD-Modell vorgegeben sind.
Nach der Fertigstellung des dreidimensionalen Formkörpers wird das verdichtete Material aus der losen Pulverschüttung 52 herausgenommen.
In der Pulverschüttung 52 können auch Fasern 40 oder sonstige Zweitphasen vorhanden sein.

Ebenso ist es möglich, durch zeitliche und/oder örtliche Steuerung der ersten und zweiten Materialzuführungen 46, 49, Materialgradienten in lateraler Ebene (senkrecht zur Aufbaurichtung 25) oder in Aufbaurichtung 25 herzustellen. Beispielsweise wird durch die erste Materialzuführung 46 das Matrixmaterial des herzustellenden Bauteils zugeführt.
Die zweite Materialzuführung 49 kann örtlich in verschiedener Konzentration Fasern, Zweitphasen oder andere Bestandteile zuführen, um den Gradienten zu erzeugen.
Die Materialzuführungen 46, 49 können in der lateralen Ebene und in Aufbaurichtung 25 bewegt werden, so dass in einem inneren und einem äusseren Bereich eine andere Materialzusammensetzung erfolgen kann, indem bspw. die erste Materialzuführung 46 im inneren Bereich 31 (Fig. 4) ein Material einer Superlegierung zuführt und die zweite Materialzufuhr 49 im äusseren Bereich 28 bspw. dasselbe Material, angereichert mit bspw. Aluminium, Chrom, oder MCrAlY zuführt (Fig. 4).

Ein Gradient in der Zusammensetzung kann in Aufbaurichtung 25 und in der dazu senkrechten Ebene vorhanden sein.
So kann bspw. eine Turbinenschaufel auf ihrer konvexen Seite eine andere Zusammensetzung aufweisen als auf der konkaven Seite. Diese Art des Gradienten ist mit einem Gussverfahren nicht zu realisieren.
Ebenso kann durch eine zeitlich veränderte Zusammensetzung des Materials, das über die Materialzuführungen 46, 49 zugeführt wird, ein Materialgradient erzeugt werden.
Wenn die Materialzuführung 46, 49 bzgl. des herzustellenden dreidimensionalen Formkörpers so ausgerichtet ist, dass dort das Material eine andere Zusammensetzung aufweisen soll, so wird die Zusammensetzung in den Materialzuführungen 46, 49 zu dem entsprechenden Zeitpunkt geändert. Dies kann sich von Zeit zu Zeit wiederholen.
Die Ausführungen zur Herstellung von Gradienten oder von Zweitphasen in dem Formkörper gelten für die verschiedenen Methoden, die in dieser Anmeldung beschrieben sind, (Fig. 2, 6, und 7)

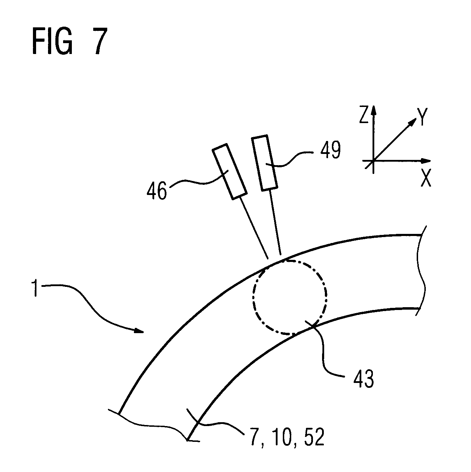

Figur 7 zeigt eine weitere Vorrichtung 1, um ein erfindungsgemässes Verfahren durchzuführen.

Es kann auch ohne Pulverpresslinge 7, 10, Pulverschüttungen 52 ein dreidimensionaler Formkörper hergestellt werden.
Die Teilmengen 7, 70 werden in Form von Pulver über die erste und/oder zweite Materialzuführung 46, 49 auf der Startplatte 4 nur den Stellen zugeführt, wo es die Geometrie des herzustellenden dreidimensionalen Formkörpers erfordert. Das zugeführte Material wird bspw. mittels Elektronenstrahlen oder Laserstrahlen 13 mit einem Laserbrennfleck 43 beaufschlagt miteinander verbunden und verdichtet.
Die Materialzuführungen 46, 49 sowie der Laser 16 bzw. seine Laserstrahlen 13 können entsprechend der gewünschten Geometrie des Formkörpers im dreidimensionalen Raum geführt werden.

## Patentansprüche

1. Verfahren zum schichtweisen Herstellen eines kompletten dreidimensionalen Formkörpers aus zumindest zwei schichtförmigen Teilmengen (7,10,52) zumindest eines ersten Ausgangsmaterials,
die den kompletten Formkörper ergeben,
wobei die Teilmengen (7,10,52) des zumindest einen Ausgangsmaterials miteinander verbunden werden.

2. Verfahren nach Anspruch 1,
**dadurch gekennzeichnet, dass**
eine Verdichtungsbehandlung mit zumindest einer der Teilmengen (7,10,52) durchgeführt wird.

3. Verfahren nach Anspruch 2,
**dadurch gekennzeichnet, dass**
eine thermische Verdichtungsbehandlung durchgeführt wird.

4. Verfahren nach Anspruch 1,
**dadurch gekennzeichnet, dass**
ein Laser (16) verwendet wird,
um die Teilmengen (7,10,52) miteinander zu verbinden.

5. Verfahren nach Anspruch 2 oder 3,
**dadurch gekennzeichnet, dass**
ein Laser (16) zur Verdichtungsbehandlung verwendet wird.

6. Verfahren nach Anspruch 1,
**dadurch gekennzeichnet, dass**
als Teilmenge (7,10) ein Pulverpressling oder ein Blech oder eine Metallfolie verwendet wird.

7. Verfahren nach Anspruch 2,
**dadurch gekennzeichnet, dass**
das Ausgangsmaterial (7,10,52) aufgeschmolzen und gerichtet erstarrt wird
so dass die Verdichtung durch eine gerichtete Erstarrung mittels epitaktischem Wachstum erfolgt.

8. Verfahren nach Anspruch 7,
**dadurch gekennzeichnet, dass**
durch die gerichtete Erstarrung ein dreidimensionaler Formkörper mit Korngrenzen gebildet wird,
wobei die Korngrenzen nur in einer Richtung (25) verlaufen.

9. Verfahren nach Anspruch 7,
**dadurch gekennzeichnet, dass**
durch die gerichtete Erstarrung ein einkristalliner dreidimensionaler Formkörper gebildet wird.

10. Verfahren nach Anspruch 7, 8 oder 9,
**dadurch gekennzeichnet, dass**
eine Startplatte (4) mit einer bestimmten kristallinen Struktur verwendet wird,
die die kristalline Struktur für den dreidimensionalen Formkörper vorgibt.

11. Verfahren nach Anspruch 1,
**dadurch gekennzeichnet, dass**
der dreidimensionale Formkörper so hergestellt wird,
dass er einen Materialgradienten aufweist.

12. Verfahren nach Anspruch 11,
**dadurch gekennzeichnet, dass**
zumindest eine der Teilmengen (7,10,52) einen Materialgradienten aufweist.

13. Verfahren nach Anspruch 11,
**dadurch gekennzeichnet,**
**dass** zumindest eine Materialzuführung (46,49) benutzt wird, um Material für den Formkörper zuzuführen, und
**dass** der Materialgradient hergestellt wird durch zeitliche und/oder örtliche Steuerung der Materialzuführungen (46,49).

14. Verfahren nach Anspruch 11 oder 13,
**dadurch gekennzeichnet,**
**dass** zumindest eine Materialzuführung (46,49) für die Zuführung von Teilmengen (7,10,52) zumindest eines Ausgangsmaterials verwendet wird, und
**dass** während einer bestimmten Zeitdauer durch die zumindest eine Materialzuführung (46, 49) Ausgangsmaterial zugeführt wird,
wobei sich während dieser Zeitdauer die Materialzusammensetzung des Ausgangsmaterials ändert,
die durch die zumindest eine Materialzufuhr (46,49) zugeführt wird,
so dass ein Materialgradient in den Teilmengen (7,10,52) erzeugt wird.

15. Verfahren nach Anspruch 11 oder 13,
**dadurch gekennzeichnet, dass**
durch zumindest zwei Materialzuführungen (46,49) Teilmengen (7,10,52) für das Ausgangsmaterial zugeführt werden,
wobei die erste Materialzuführung (46) eine erste Materialzusammensetzung zuführt und
die zweite Materialzuführung (49) ein zweite Materialzusammensetzung zuführt,
und die das beiden Materialzuführungen (46,49) jeweilige Material an verschiedenen Stellen zuführen,
so dass ein Materialgradient in den Teilmengen (7,10,52) erzeugt wird.

16. Verfahren nach Anspruch 4 oder 5,
**dadurch gekennzeichnet, dass**
die Geometrie des herzustellenden dreidimensionalen Formkörpers durch eine Bewegung der Laserstrahlen (13) des Lasers (16) über die Teilmengen (7,10,52) festgelegt wird.

17. Verfahren nach Anspruch 1 oder 10,
**dadurch gekennzeichnet, dass**
eine Zusatzheizung (34) verwendet wird,
um die Startplatte (4) und/oder das Ausgangsmaterial (7,10,52) aufzuheizen oder
auf einer bestimmten Temperatur zu halten.

18. Verfahren nach Anspruch 1,
**dadurch gekennzeichnet, dass**
der Formkörper nur aus schichtförmigen Teilmengen (7,10,52) gebildet wird.

19. Verfahren nach Anspruch 1,
**dadurch gekennzeichnet, dass**
die schichtförmigen Teilmengen (7,10) eine Dicke von 0,1 mm bis 1cm haben.

20. Verfahren nach Anspruch 1,
**dadurch gekennzeichnet, dass**
der Formkörper senkrecht zu einer Ebene,
in der sich die schichtförmigen Teilmengen (7,10) erstrecken,
länger ist als die Ausdehnung des Formkörpers in dieser Ebene.
